# EUROPEAN PATENT APPLICATION

(11) **EP 2 381 496 A1**
(43) Date of publication of application: **26.10.2011**
(21) Application number: 11002648.1
(22) Date of filing: 30.03.2011
(51) Int. Cl.: H01L 33/60

(54) **Substrate for mounting light-emitting element and light-emitting device employing the substrate**

(30) Priority: 02.04.2010 JP 2010086084
(71) Applicant: Asahi Glass Company, Limited, Chiyoda-ku Tokyo 100-8405 (JP)
(72) Inventor: Masamichi, Tanida, Tokyo 100-8405 (JP); Toshihisa, Okada, Tokyo 100-8405 (JP)
(74) Representative: Müller-Boré & Partner Patentanwälte

(57) **Abstract**

To provide a substrate for mounting a light-emitting element, which is provided with a reflection layer having a high optical reflectance and being less susceptible to deterioration of the reflectance due to corrosion and which has an improved light extraction efficiency and heat dissipation property, and a light-emitting device employing such a substance.

A substrate for mounting a light-emitting element, which comprises a substrate main body (1) having a mounting surface on which a light-emitting element is to be mounted, a reflection layer (2) formed on a part of the mounting surface of the substrate main body and containing silver, and a vitreous insulating layer (3) formed on the reflection layer and composed of glass and a ceramic filler, wherein the vitreous insulating layer has a surface non-planarity of at most 5 µm in a span of 300 µm.

## Description

### TECHNICAL FIELD

The present invention relates to a substrate for mounting a light-emitting element and a light-emitting device employing it, particularly to a substrate for mounting a light-emitting element capable of preventing deterioration of the reflectance, and a light-emitting device employing it.

### BACKGROUND ART

In recent years, along with a tendency to high brightness and whitening of a light-emitting element such as a light-emitting diode (LED) element, a light-emitting device employing a light-emitting element has been used for illumination, backlights of various displays or large-sized liquid crystal TVs, etc. The substrate for mounting a light-emitting element, to mount a light-emitting element, is usually required to have a high reflectivity to efficiently reflect light emitted from the element.

Accordingly, it has been heretofore attempted to provide a reflection layer on the substrate surface for the purpose of reflecting light emitted from a light-emitting element to a forward direction as far as possible. As such a reflection layer, a silver reflection layer having a high reflectance is employed.

However, silver is likely to be corroded, and if it is left to stand, a compound such as Ag₂S is likely to be formed, whereby the optical reflectance tends to deteriorate. To prevent such a problem, a method has been proposed wherein the surface of silver is coated with a resin such as a silicon resin, an acrylic resin, an epoxy resin or an urethane resin (Patent Document 1). However, by such a method, moisture or a corrosive gas is likely to enter into the resin or from the interface between the silver reflection layer and the resin, whereby the silver reflection layer is corroded as the time passes, and thus it has been difficult to apply such a method to products which are required to have a reliability for a long period of time.

Accordingly, in order to prevent corrosion of a silver reflection layer, a method has been proposed to coat the surface of silver with a glass layer (Patent Document 2). However, the glass layer disclosed in this document undergoes crystallization during the firing, and shrinkage of the glass layer is substantially different from the shrinkage of the substrate during the firing, whereby the fired substrate is likely to have warpage, and thus, such a method has been inadequate for application to products. Further, there has been also a problem of so-called silver coloring i.e. the silver reflection layer is likely to be reacted with the glass layer during the firing to form a color of yellow to brown.

Further, a method has been proposed to coat the silver reflection layer with a glass layer less susceptible to silver coloring (Patent Document 3). In this case, a powdery glass is formed into a paste, which is applied and dried on a silver reflection layer formed on a substrate and fired simultaneously with the substrate to obtain a glass layer, but in order to obtain a good covering property, it is necessary to use a glass which sufficiently flows during the firing.

### PRIOR ART DOCUMENTS

### PATENT DOCUMENTS

Patent Document 1: JP-A-2007-067116
Patent Document 2: JP-A-2009-231440
Patent Document 3: WO2010/021367

### DISCLOSURE OF INVENTION

### TECHNICAL PROBLEM

As mentioned above, in order to prevent corrosion of the silver reflection layer, it has been attempted to coat it with a glass layer. However, along with downsizing of a light-emitting element or downsizing of a substrate for mounting a light-emitting element, a phenomenon of deterioration in the heat dissipation efficiency has been observed even though a heat dissipation measure has been applied to a substrate for mounting a light-emitting element.

The cause for such a phenomenon has been studied, and it has been found that the heat dissipation effect is deteriorated especially in a case where an element-connection terminal is formed in the vicinity of the light-emitting element-mounting portion. Further, when a substrate for mounting a light-emitting element having an element-connection terminal formed thereon was analyzed, an edge portion of a glass layer to protect a silver reflection layer was found to be thicker than other portions. That is, it was found that the glass layer surface had a swell, and when a light-emitting element was mounted on the glass layer, a space was created between the light-emitting element and the glass layer, and a resin having a small thermal conductivity was filled to close the space thereby to fix the light-emitting element, whereby the thermal conductivity was deteriorated.

The above mentioned "edge portion of a glass layer" includes not only the outer peripheral edge portion of the glass layer but also the periphery surrounding a hole (a hole formed for e.g. the element-connection terminal) in the glass layer, formed on the light-emitting element-mounting surface.

Under the above circumstances, it is an object of the present invention to provide a substrate for mounting a light-emitting element, which has a high planarity at the light-emitting element-mounting portion and which is excellent in the heat dissipation property for a light-emitting element, and a light emitting device employing such a substrate.

### SOLUTION TO PROBLEM

Heretofore, in order to obtain a good covering property, it has been pursued to improve the fluidity of glass during the firing. However, as the fluidity has been improved, an influence of the surface tension has become larger than the viscosity resistance of glass, and it has been found that the edge portion of a covering pattern of the glass layer becomes thicker than a portion inside from the edge portion of the pattern, and a swell results on the surface.

From this mechanism, the present inventors considered that in order to suppress the swell of the covering glass layer surface, it may be effective to raise the softening point of glass constituting the covering glass layer and to increase the glass viscosity during the firing. However, at the same time, it was conceivable that if the softening point of glass is raised, there may be a negative aspect such that simultaneous firing with a reflective layer containing silver tends to be difficult, fluidity decreases during the firing, or sintering tends to be inadequate.

Therefore, it has been studied to suppress the surface swell by mixing a ceramic filler into the glass to form a vitreous insulating layer, whereby it has been found possible to suppress the swell and to obtain one excellent also in the heat dissipation property, by employing fine particles as the ceramic filler to be mixed.

In order to solve the above problem, the present invention provides a substrate for mounting a light-emitting element, which comprises a substrate main body having a mounting surface on which a light-emitting element is to be mounted, a reflection layer formed on a part of the mounting surface of the substrate main body and containing silver, and a vitreous insulating layer formed on the reflection layer and composed of glass and a ceramic filler, wherein the maximum swell as measured from an edge of the vitreous insulating layer is at most 5 µm. Further, the above ceramic filler has an average particles size (D₅₀) of at most 2.5 µm, and such a fine particulate ceramic filler is contained in an amount of at most 40 vol% in the vitreous insulating layer.

Further, the light-emitting device of the present invention is one comprising the above substrate for mounting a light-emitting element, and a light-emitting element mounted on the mounting surface of the substrate main body.

### ADVANTAGEOUS EFFECTS OF INVENTION

By the substrate for mounting a light-emitting element of the present invention, the following effects can be expected.

A fine particulate ceramic filler is incorporated in the glass constituting the vitreous insulating layer, whereby it is possible to suppress a swell of the surface of the vitreous insulating layer. Accordingly, a space between the light-emitting element and the vitreous insulating layer can be reduced, and it is thereby possible to increase the effect to dissipate heat via the vitreous insulating layer to the silver reflection layer located immediately thereunder. Further, since the ceramic filler is in the form of fine particles, scattering of light is very little, whereby light from the reflection layer can be emitted in a straight line without being scattered.

The light-emitting device of the present invention employs such a substrate for mounting a light-emitting element, whereby the reflectance of the reflection layer tends to scarcely deteriorate, and it is expected to maintain the light-emitting efficiency for a long period of time and to be excellent in the heat dissipation property.

### BRIEF DESCRIPTION OF DRAWINGS

Fig. 1 is a cross-sectional view illustrating an example of the substrate to be used in the present invention.
Fig. 2 is a cross-sectional view illustrating an example wherein a light-emitting element is disposed on the substrate to be used in the present invention.
Fig. 3 is a cross-sectional view illustrating an example of the light-emitting device of the present invention.
Fig. 4 is a top view and a cross-sectional view illustrating an example wherein a light-emitting element is disposed on the substrate in the light-emitting device of the present invention.
Fig. 5 is views illustrating the surface states of parts of the light-emitting element-mounting surfaces of Examples 1 and 3 in Table 1.

### DESCRIPTION OF EMBODIMENTS

The substrate for mounting a light-emitting element of the present invention is characterized in that it comprises a substrate main body having a mounting surface on which a light-emitting element is to be mounted, a reflection layer formed on a part of the mounting surface of the substrate main body and containing silver, and a vitreous insulating layer formed on the reflection layer and composed of a glass and a ceramic filler, and it has a planarity such that the maximum swell as measured from an edge of the vitreous insulating layer is at most 5 µm. Further, it is characterized in that such a vitreous insulating layer can be sintered at a temperature of at most 900°C and contains at most 40 vol% of a fine particulate ceramic filler having an average particle size of at most 2.5 µm.

Here, the "edge of the vitreous insulating layer" has the same meaning as the "edge portion of the glass layer" and includes not only the outer peripheral edge of the vitreous insulating layer but also the periphery surrounding a hole (a hole formed for e.g. an element-connection terminal) of the vitreous insulating layer formed on the light-emitting element-mounting surface.

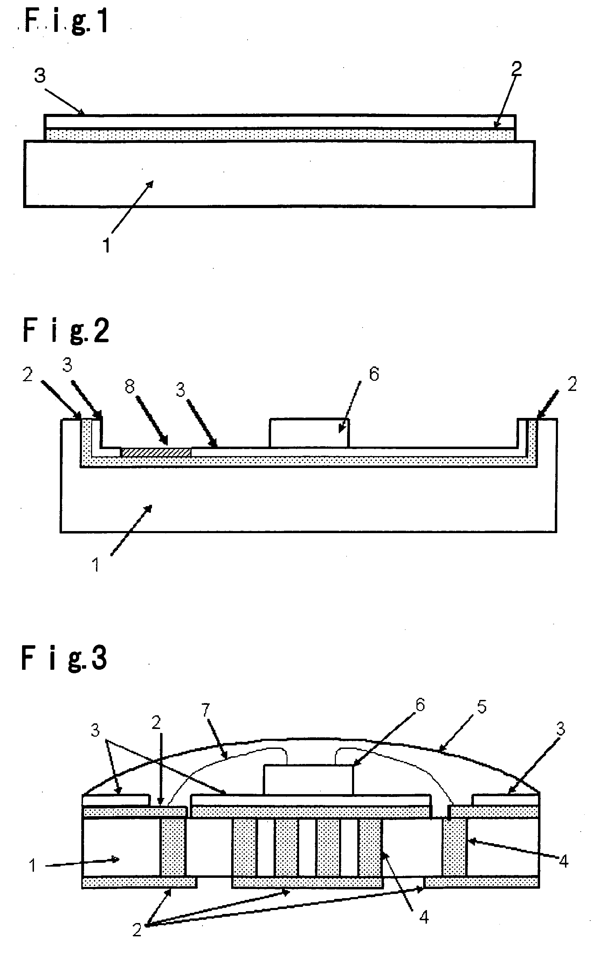

The substrate main body may be an entirely flat plate-like component as shown in Fig. 1 or a component having a concave formed so that the light-emitting element-mounting surface is located one step down as shown in Fig. 2. The material constituting the substrate is not particularly limited, but is preferably an inorganic material, since the glass to be used for the vitreous insulating layer has to be baked thereon. From the viewpoint of the thermal conductivity, the heat-dissipation property, the strength, the cost, etc., alumina ceramics, low temperature co-fired ceramics (hereinafter referred to as LTCC), aluminum nitride, etc. may be mentioned. In the case of LTCC, it is possible to form the substrate, the reflective layer and the vitreous insulating layer to cover the reflective layer, by co-firing. Further, in the case of LTCC, formation of internal wirings within the substrate will also be easy.

For the reflection layer, silver is mainly used because of its high reflectance, but a metal such as a silver/palladium mixture or a silver/platinum mixture may also be used.

The vitreous insulating layer is a layer to protect the underlying reflection layer from corrosion (particularly from oxidation or sulfurization of silver, etc.), etc. In order to satisfy both the sufficient covering property and the surface planarity, it is preferably one containing a glass and a ceramic filler. The glass contained in the vitreous insulating layer can be sintered at a temperature of at most 900°C. This glass is a component to make the vitreous insulating layer dense.

The ceramic filler may be at least one member selected from a silica filler, an alumina filler, a zirconia filler and a titania filler. And, with respect to the particle size, it is possible to use one having an average particle size D₅₀ (hereinafter sometimes referred to simply as D₅₀) of at most 2.5 µm. Particularly preferred is one having a D₅₀ of at most 0.5 µm. In this specification, D₅₀ is a value measured by a laser diffraction method.

The content of the ceramic filler in the vitreous insulating layer may be determined by the particle size. When D₅₀ is from 1 to 2.5 µm, the content is from 10 to 40 vol%. The upper limit is preferably at most 35 vol%, more preferably at most 30 vol%. The lower limit is preferably at least 13 vol%, more preferably at least 17 vol%.

When D₅₀ is less than 1 µm, the content is from 1 to 20 vol%. The upper limit is preferably at most 15 vol%, more preferably at most 10 vol%. The lower limit is preferably at least 2 vol%.

If the ceramic filler is incorporated beyond both upper limits, the fluidity of the vitreous insulating layer tends to be deteriorated, and sintering deficiency is likely to result. On the other hand, if the content is less than both lower limits, the effect to reduce the maximum swell tends to be hardly obtainable.

The surface planarity of the vitreous insulating layer is preferably such that the maximum swell as measured from its edge is at most 5 µm. If the maximum swell exceeds 5 µm, a portion where a space between the light-emitting element and the mounting surface is broadened at the time of mounting a light-emitting element, is likely to result, whereby the heat dissipation property is likely to be deteriorated. The maximum swell is preferably at most 4 µm, more preferably at most 3 µm.

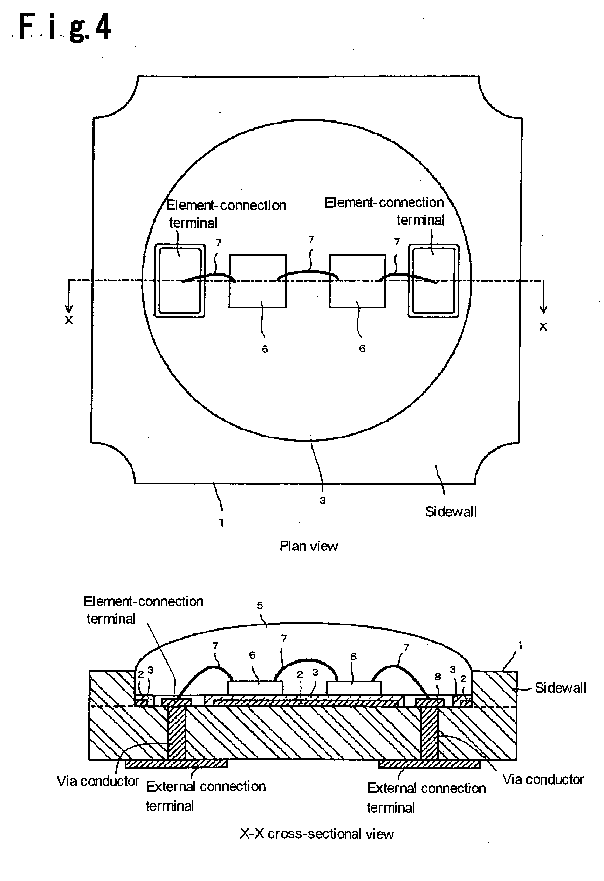

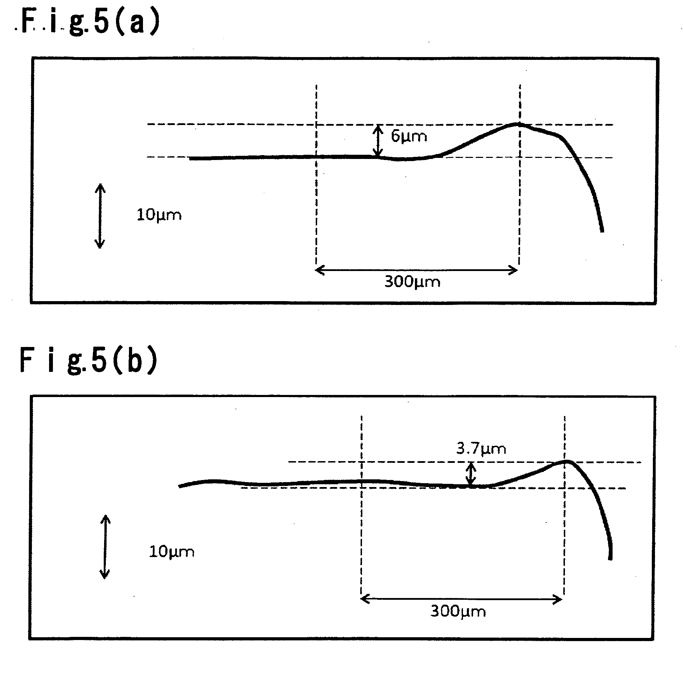

Further, this maximum swell is preferably measured in a certain distance from the edge. The distance is at least 200 µm, preferably at least 300 µm. If the distance for such measurement is shorter than 200 µm, only the inclined surface of swell may be measured, and the maximum swell may not be measured. Otherwise, as shown in Fig. 5, the measurement is made from the edge to measure the above mentioned certain distance from the maximum height. By measuring the maximum swell from the maximum height, it is possible to measure the desired maximum swell value irrespective of the presence or absence of a component (e.g. a sidewall, an element-connection terminal or the like) adjacent to the edge of the vitreous insulating layer. For example, in a case where the maximum swell is measured from the edge of the vitreous insulating layer around an element-connection terminal as shown in Fig. 4 (in the absence of a component adjacent to the edge), the maximum swell to be measured may possibly be the distance from the edge (e.g. the light-emitting element-mounting surface) to the maximum height. That is, this value includes the thickness of the vitreous insulating layer, and therefore, in order to obtain the desired value, it becomes necessary to omit the thickness of the vitreous insulating layer.

The above glass is preferably one which can be fired simultaneously with the reflection layer, more preferably one not to form defects such as open pores by a reaction with silver when fired simultaneously with the reflection layer. That is, when fired simultaneously with the reflection layer, the vitreous insulating layer is one which can be sintered and densified at a firing temperature selected within a range of from 500 to 900°C, to meet with the material for the substrate main body to be used.

When the vitreous insulating layer is fired in such a form as to cover the reflection layer, silver ions will diffuse into the glass constituting the vitreous insulating layer. And, such silver ions diffused into the glass may react with a silicone resin filled for sealing on the vitreous insulating layer and may undergo a color change to brown under a high temperature and high humidity condition, depending upon the glass composition or others including the substrate material constituting the substrate for mounting a light-emitting element, the metal material containing silver, the atmosphere or temperature conditions for the firing, etc. To prevent such a color change, it may be effective not to incorporate alumina as the ceramic filler constituting the vitreous insulating layer.

As the light-emitting element, an LED element may be mentioned. More specifically, it may be one which emits visible light as a phosphor is excited by radiated light, and a blue-emitting type LED element or an ultraviolet-emitting type LED element may, for example, be mentioned. However, the light-emitting element is not limited to such specific examples, and various light-emitting elements may be used depending upon the particular applications of the light-emitting devices, the desired emission colors, etc., so long as they are light-emitting elements capable of emitting visible light by excitation of a phosphor.

The light-emitting device of the present invention is preferably provided with a phosphor layer. The phosphor is one to be excited by light radiated from a light-emitting element or by light reflected from a reflection layer, to emit visible light and to obtain a desired emission color as a light-emitting device, by color mixing of this visible light and light radiated from the light-emitting element or by color mixing of visible light emitted from the phosphor or the visible light itself. The type of the phosphor is not particularly limited and may suitably be selected depending upon the desired emission color, light radiated from the light-emitting element, etc.

The phosphor layer is formed as a layer wherein the phosphor is mixed and dispersed in a transparent resin such as a silicone resin or an epoxy resin. The phosphor layer may be formed to cover the outside of a light-emitting element (see Fig. 3), but the phosphor layer may be separately provided on a coating layer formed to directly cover the light-emitting element. That is, the phosphor layer is preferably formed as the topmost layer on the side where a light-emitting element of the light-emitting device is formed.

The light emitting device of the present invention is typically one having connection terminal areas to electrically connect a light-emitting element on the surface of the substrate, and the region excluding such connection terminal areas is covered by the vitreous insulating layer. In such a case, mounting of the light-emitting element may be carried out, for example, by a method wherein the light-emitting element is bonded (die-bonded) on the substrate by means of an epoxy resin or a silicone resin, and electrodes on the upper surface of the light-emitting element are connected to pad portions of the substrate via bonding wires such as gold wires, or a method wherein a bump electrode such as a solder bump, an Au bump or an Au-Sn eutectic crystal bump provided on the rear side of the light-emitting element is connected to a lead terminal or pad portion of the substrate by flip-chip bonding.

The substrate main body is not particularly limited so long as the reflective layer and the vitreous insulating layer to protect the reflection layer may be formed thereon. However, in the following, a case wherein the substrate main body is an LTCC substrate, will be described.

The LTCC substrate is a substrate which is prepared by firing a mixture of a glass powder with a refractory filler such as an alumina powder and is a substrate which can be prepared by co-firing together with the reflection layer containing silver and the vitreous insulating layer. Here, "the reflection layer containing silver" means that in a case where the reflection layer is formed by a silver paste, a component for forming the paste, which is contained in the silver paste, may be contained as remained in the formed reflection layer, or the reflection layer may contain other components to improve the durability of silver. The reflection layer containing silver means a reflection layer containing at least 90 mass% of silver, and may be a silver alloy. For example, palladium may be contained up to 10 mass%, and platinum may be contained up to 3 mass%.

The glass powder and the refractory filler such as an alumina powder to be used for the LTCC substrate are used usually as formed into a green sheet. For example, firstly, the glass powder and the alumina powder or the like are mixed with a resin such as a polyvinyl butyral or an acrylic resin, if necessary, by an addition of e.g. a plasticizer such as dibutyl phthalate, dioctyl phthalate or butyl benzyl phthalate. Then, a solvent such as toluene, xylene or butanol is added thereto to form a slurry, and this slurry is formed into a sheet on a film of e.g. polyethylene terephthalate by e.g. a doctor blade method. Finally, the one formed into a sheet is dried to remove the solvent to obtain a green sheet. On such a green sheet, circuit patterns, vias, etc. may be formed by e.g. screen printing by means of a silver paste, as the case requires.

The glass composition constituting the LTCC substrate is not particularly limited and may, for example, comprise, as represented by mol%, 60.4% of SiO₂, 15.6% of B₂O₃, 6% of Al₂O₃, 15% of CaO, 1 % of K₂O and 2% of Na₂O.

The glass powder to be used for the production of the LTCC substrate is produced by grinding glass obtained by a melting method. The grinding method is not particularly limited so long as the object of the present invention is not impaired and may be either wet grinding or dry grinding. In the case of wet grinding, it is preferred to use water as a solvent. Further, for grinding, a grinding machine such as a roll mill, a ball mill or a jet mill may suitably be used. The glass after grinding may be dried and classified as the case requires.

The particle size, shape, etc. of the alumina powder are not particularly limited. Typically, however, one having an average particle size D₅₀ of from about 3 to 5 µm may be used. For example, AL-45H manufactured by Showa Denko K.K. may be mentioned. The blend ratio of the glass powder to the alumina powder is typically 40 mass% of the glass powder to 60 mass% of the alumina powder.

The above-mentioned green sheet is fired and then processed into a desired shape, as the case requires, to obtain a substrate. In such a case, the object to be fired is a single green sheet or one having a plurality of green sheets laminated. The firing is carried out typically at a temperature of from 800 to 900°C for from 20 to 60 minutes. A more typical firing temperature is from 850 to 880°C.

Now, the vitreous insulating layer will be described. The vitreous insulating layer is preferably a layer containing a glass and a ceramic filler. An example of the glass to be used here is one comprising, as represented by mol% based on oxides, from 20 to 85% of SiO₂, from 0 to 40% of B₂O₃, from 0 to 20% of Al₂O₃, from 0 to 50% of at least one member selected from MgO, CaO, SrO and BaO, and from 0 to 16% of at least one of Na₂O and K₂O.

The thickness of the vitreous insulating layer is typically from 5 to 30 µm. If it is less than 5 µm, the covering property tends to be inadequate, and therefore, the thickness is preferably at least 5 µm. If it exceeds 30 µm, the heat dissipation property of the light-emitting element is likely to be hindered, and the luminous efficiency is likely to be low.

The vitreous insulating layer may be formed, for example, by forming a glass powder into a paste, which is then screen-printed and fired. However, the method is not particularly limited so long as it is method which is capable of forming one having a thickness of typically from 5 to 30 µm to be flat.

In the present invention, the vitreous insulating layer preferably contains at least 60% of the glass as represented by volume%. If it is less than 60%, sintering during the firing tends to be inadequate, and the covering property is likely to be impaired. The content is more preferably at least 70% in order to improve the sinterability. Further, it contains at most 40% of a ceramic filler. The content of the ceramic filler is typically at least 1%. As the vitreous insulating layer contains the ceramic filler, the surface swell of the vitreous insulating layer can be reduced, and the heat dissipation property can be made high.

The ceramic filler is preferably fine particles to reduce the surface swell of the vitreous insulating layer after the firing, and D₅₀ is preferably at most 1.0 µm, more preferably at most 0.5 µm. D₅₀ is further preferably at most 0.1 µm, whereby a very smooth surface can be realized even by a small content of such a ceramic filler. Further, scattering of light is minimized, whereby it is possible to provide a characteristic such that light from the reflection layer is radiated in a straight line without being scattered. Its material is not particularly limited so long as it does not bring about absorption which impairs the reflectance.

### EXAMPLES

Now, Examples of the present invention will be described with reference to Fig. 4. However, it should be understood that the present invention is by no means restricted to such Examples.

### EXAMPLE 1

Firstly, a green sheet was prepared to prepare a substrate main body 1 of a substrate for mounting a light-emitting element. For the green sheet, raw materials were blended and mixed so that SiO₂ became 60.4 mol%, B₂O₃ 15.6 mol%, Al₂O₃ 6 mol%, CaO 15 mol%, K₂O 1 mol% and Na₂O 2 mol%, and this raw material mixture was put into a platinum crucible and melted at 1,600°C for 60 minutes, whereupon this molten state glass was cast and cooled. The obtained glass was ground for 40 hours by a ball mill made of alumina to produce a glass powder for a substrate main body. Here, ethyl alcohol was used as a solvent during the grinding.

A glass ceramic composition was prepared by blending and mixing so that this glass powder for a substrate main body became 40 mass% and an alumina filler (tradename: AL-45H, manufactured by Showa Denko K.K.) became 60 mass%. To 50 g of this glass ceramic composition, 15 g of an organic solvent (one having toluene, xylene, 2-propanol and 2-butanol mixed in a mass ratio of 4:2:2:1), 2.5 g of a plasticizer (di-2-ethylhexyl phthalate), 5 g of polyvinyl butyral (tradename: PVK#3000K, manufactured by Denka K.K.) as a binder and 0.5 g of a dispersing agent (tradename: BYK180, manufactured by BYK-Chemie) were blended and mixed to prepare a slurry.

This slurry was applied on a PET film by a doctor blade method and dried to prepare a green sheet, of which the thickness after firing would be 0.15 mm.

Then, a reflection layer 2 is formed by applying a silver paste on the substrate main body 1, followed by firing. This silver paste was prepared by blending a silver powder (tradename: S400-2, manufactured by DAIKEN CHEMICAL CO., LTD.) and ethyl cellulose as a vehicle in a mass ratio of 90:10, and dispersing them in α-terpineol as a solvent so that the solid content would be 87 mass%, followed by kneading for one hour in a porcelain mortal and further by dispersion three times by means of a three roll mill.

Then, a vitreous insulating layer 3 is formed by forming a mixture of a glass powder and a ceramic filler powder into a glass paste, which is coated on the reflection layer 2, followed by firing. At that time, the glass paste was pattern-printed not to completely cover an element-connection terminal formed on the light-emitting element-mounting surface side of the substrate main body 1. The glass powder used for the preparation of this glass paste was prepared as follows. Firstly, raw materials were blended and mixed so that they became mol% of the glass composition as disclosed in Table 1, and this raw material mixture was put in a platinum crucible and melted at 1,600°C for 60 minutes, whereupon this molten state glass was cast and cooled. This glass was ground for from 8 to 60 hours by a ball mill made of alumina to obtain a glass powder for glass film. This glass powder and a ceramic filler were mixed in a ratio shown in Table 1. 60 Mass% of this mixture and 40 mass% of a resin component (one containing ethyl cellulose and α-terpineol in a mass ratio of 85:15) were blended and kneaded for one hour in a porcelain mortar and further dispersed three times by means of a three roll mill to prepare a glass paste. In Table 1, Example 1 and Example 5 are Comparative Examples, and Examples 2 to 4 and 6 to 7 are Working Examples of the present invention.

And, on the surface of the green sheet obtained as described above, the silver paste and the glass paste were applied by a screen printing method to form a green sheet for reflection surface. And, a green sheet having no such pastes applied was laminated so that the glass paste of the green sheet for reflection surface became the upper side i.e. the outermost layer. And, on the glass paste side of the green sheet for reflection surface, a green sheet having holes formed for mounting a light-emitting element to constitute a sidewall, is further laminated and bonded by hot pressing for integration to obtain a non-fired substrate for mounting a light-emitting element. Then, the substrate was held at 550°C for 5 hours to carry out binder burnout and further held at 870°C for 30 minutes to carry out firing to obtain a substrate for mounting a light-emitting element.

With respect to the surface of the vitreous insulating layer 3, the surface contour was measured by a stylus surface roughness/contour measuring apparatus (SURFCOM, manufactured by TOKYO SEIMITSU CO., LTD.). The results obtained by measuring the maximum swells in Examples 1 and 3 as shown in Table 1 are illustrated in Fig. 5. Fig. 5(a) is a view showing the measured results in Example 1, and Fig. 5(b) is a view showing the measured results in Example 3. The maximum swell is one measured from the light-emitting element side edge of the element-connection terminal on the right hand side shown in the plan view of Fig. 4 towards the light-emitting element, and the measured distance is a length from the maximum height to 300 µm.

A light-emitting device was prepared by mounting two light-emitting diode elements of two wire type between a pair of element-connection terminals on a mounting surface of the insulating protective layer on the experimental substrate for mounting a light-emitting element prepared as described above. Specifically, the light-emitting diode elements (tradename: GQ2CR460Z, manufactured by Showa Denko K.K.) were fixed at the above-mentioned positions by a die-bond material (tradename: KER-3000-M2, manufactured by Shin-Etsu Chemical Co., Ltd.), and outside ones of pairs of electrodes of the two light-emitting elements were electrically connected to the element-connection terminals located on the outsides of the respective light-emitting elements, respectively, via bonding wires. Further, inside ones of pairs of electrodes of the two light-emitting elements were electrically bonded to each other via a bonding wire.

Further, by means of a sealing agent (tradename: SCR-1016A, manufactured by Shin-Etsu Chemical Co., Ltd.), sealing was carried out to constitute the sealing layer shown in Figs. As the sealing agent, one containing 20 mass% of a phosphor (tradename P46-Y3, manufactured by Kasei Optonix, Ltd.) was used.

### EVALUATION

With respect to the light-emitting devices obtained in Examples 1 to 7 shown in Table 1, the thermal resistance was measured by the following method.

### THERMAL RESISTANCE

The thermal resistance of the substrate for mounting a light-emitting element in each light-emitting device was measured by means of a thermal resistance-measuring device (tradename: TH-2167, manufactured by Mine Koon Denki K.K.). Here, the applied electric current was 35 mA, and the electric current was conducted until the voltage drop was saturated, whereby the saturation temperature was calculated by a temperature coefficient led from the dropped voltage and the temperature-voltage drop characteristic of the light-emitting element, and the thermal resistance was obtained.

The results are shown in Table 1. Here, the results are represented by percentages when the thermal resistance in a conventional light-emitting device having a glass layer containing no ceramic filler is regarded to be 100%. The numerical value being small means that the heat dissipation property is good, and the numerical value being large means that the heat dissipation property is poor.

A prescribed electric current was supplied to a prepared light-emitting device, and the temperature of the light-emitting element portion was measured when it became stationary, whereby the heat dissipation property was evaluated. The results are shown in Table 1. A flat one with the maximum swell being at most 5 µm had a thermal resistance of at most about 80%, and thus, it was confirmed that the heat dissipation property is high.

Further, with respect to the total luminous flux to be obtainable, no deterioration by silver coloring was observed even when the device was used for a long period of time.

**TABLE 1**

| Ex. No. | 1 | 2 | 3 | 4 | 5 | 6 | 7 |
|---|---|---|---|---|---|---|---|
| Glass composition | | | | | | | |
| SiO₂ | 81.6 | 81.6 | 81.6 | 81.6 | 81.6 | 60.4 | 60.4 |
| B₂O₃ | 16.6 | 16.6 | 16.6 | 16.6 | 16.6 | 15.6 | 15.6 |
| Al₂O₃ | 0 | 0 | 0 | 0 | 0 | 6 | 6 |
| CaO | 0 | 0 | 0 | 0 | 0 | 15 | 15 |
| K₂O | 1.8 | 1.8 | 1.8 | 1.8 | 1.8 | 1 | 1 |
| Na₂O | 0 | 0 | 0 | 0 | 0 | 2 | 2 |
| | | | | | | | |
| Glass (vol%) | 100 | 86 | 95 | 98 | 93 | 62 | 53 |
| Ceramic filler (vol%) | | 14 | 5 | 2 | 7 | 38 | 47 |
| Alumina (vol%) | | 14 | | | | 38 | 33 |
| Average particle size (µm) | | 2.0 | | | | 2.0 | 2.1 |
| Specific surface area (m²/g) | | 1 | | | | 1 | 1.8 |
| Specific surface area (m²/cm³) | | 4 | | | | 4 | 7 |
| Silica (vol%) | | | 5 | 2 | 7 | | |
| Average particle size (µm) | | | 0.01 | 0.01 | 1.0 | | |
| Specific surface area (m²/g) | | | 300 | 300 | 5 | | |
| Specific surface area (m²/cm³) | | | 700 | 700 | 11.5 | | |
| Zirconia (vol%) | | | | | | | 14 |
| Average particle size (µm) | | | | | | | 0.4 |
| Specific surface area (m²/g) | | | | | | | 8 |
| Specific surface area (m²/cm³) | | | | | | | 48 |
| Tg(°C) | 480 | 480 | 480 | 480 | 480 | 640 | 640 |
| Maximum swell (µm) | 6 | 2 | 3.7 | 5 | 6 | 2 | 3 |

| Heat dissipation property | | | | | | | |
|---|---|---|---|---|---|---|---|
| Thermal resistance (%) | 100 | 73 | 73 | 78 | 92 | 73 | 82 |

### INDUSTRIAL APPLICABILITY

The present invention is useful for backlights of e.g. mobile phones or large size liquid crystal TVs.

### MEANING OF SYMBOLS

- 1:: LTCC substrate
- 2:: Conductor layer (reflection layer)
- 3:: Vitreous insulating layer
- 4:: Via conductor
- 5:: Sealing resin (phosphor layer)
- 6:: Light-emitting element
- 7:: Bonding wire
- 8:: Gold-plated layer

The entire disclosure of Japanese Patent Application No. 2010-086084 filed on April 2, 2010 including specification, claims, drawings and summary is incorporated herein by reference in its entirety.

## Claims

1. A substrate for mounting a light-emitting element, which comprises a substrate main body having a mounting surface on which a light-emitting element is to be mounted, a reflection layer formed on a part of the mounting surface of the substrate main body and containing silver, and a vitreous insulating layer formed on the reflection layer and composed of glass and a ceramic filler, wherein the maximum swell as measured from an edge of the vitreous insulating layer is at most 5 µm.

2. The substrate for mounting a light-emitting element according to Claim 1, wherein the maximum swell is as measured in a distance of up to 300 µm from the edge of the vitreous insulating layer.

3. The substrate for mounting a light-emitting element according to Claim 1 or 2, wherein the vitreous insulating layer contains at most 40 vol% of a ceramic filler having an average particle size of at most 2.5 µm.

4. The substrate for mounting a light-emitting element according to any one of Claims 1 to 3, wherein connection terminal areas for the light-emitting element are formed on the substrate main body, and the vitreous insulating layer is formed in a region other than the connection terminal areas.

5. The substrate for mounting a light-emitting element according to any one of Claims 1 to 4, wherein the mounting surface is a concave formed in the substrate main body.

6. A light-emitting device comprising the substrate for mounting a light-emitting element as defined in any one of Claims 1 to 5, a light-emitting element mounted on the vitreous insulating layer of the substrate, and a phosphor layer formed to cover the light-emitting element.
